Europäisches Patentamt

(19) European Patent Office

Office européen des brevets

(11) Publication number: **0 185 425**
**B1**

(12) **EUROPEAN PATENT SPECIFICATION**

(45) Date of publication of patent specification: **13.06.90**

(51) Int. Cl.⁵: **H 03 M 13/22,** H 03 M 13/00, G 11 B 20/18

(21) Application number: **85202036.1**

(22) Date of filing: **10.12.85**

(54) **Method of, and device for, decoding a repeatedly accesible information stream which is protected by a symbol-correction code.**

(30) Priority: **17.12.84 NL 8403818**

(43) Date of publication of application:
**25.06.86 Bulletin 86/26**

(45) Publication of the grant of the patent:
**13.06.90 Bulletin 90/24**

(84) Designated Contracting States:
**AT DE FR GB NL SE**

(56) References cited:
**EP-A-0 056 823**
**DE-A-3 241 950**
**NL-A-8 300 249**
**US-A-4 175 692**
**US-A-4 251 863**

**ELECTRONIC ENGINEERING, vol. 55, no. 682, October 1983, pages 47-49, London, GB; T. JARRETT: "Microfloppy disk drives"**

**PATENTS ABSTRACTS OF JAPAN, vol. 2, no. 16, 31st January 1978, page 10854 E 77; & JP - A - 52 132 705 (HITACHI SEISAKUSHO) 11.07.1977**

(73) Proprietor: **N.V. Philips' Gloeilampenfabrieken Groenewoudseweg 1
NL-5621 BA Eindhoven (NL)**

(72) Inventor: **Baggen, Constant Paul Marie J.
c/o INT. OCTROOIBUREAU B.V. Prof. Holstlaan 6
NL-5656 AA Eindhoven (NL)**

(74) Representative: **Strijland, Wilfred et al
INTERNATIONAAL OCTROOIBUREAU B.V. Prof. Holstlaan 6
NL-5656 AA Eindhoven (NL)**

Courier Press, Leamington Spa, England.

## Description

The invention relates to a method for decoding an information stream comprising a succession of channel symbols that are wordwise protected by a symbolcorrecting code, said method comprising the steps of:

a. demodulating said channel symbols to associated code symbols and collecting the code symbols in an intermediate memory until a complete code word is present.

b. decoding and, if possible and necessary, correcting the code word by means of redundancy symbols which are included in the code symbols, with indicating by means of a decode flag the decoding reliability, said decode flag having a value which is different for a reliably decoded symbol versus a non-reliably decoded symbol.

Such a method is known from earlier Netherlands Patent Application 8300249. In general, Reed-Solomon codes form a known group of symbol correction codes, but other codes of this kind also exist, for example M.D.S. (minimum distance separable) codes. According to a Reed-Solomon code $t$ incorrect symbols can be located and corrected within a code word. Furthermore, $e$ incorrect symbols can be corrected subject to the condition that the locations are known. Finally, $d$ incorrect symbols can be detected. When a code word contains (n-k) redundant symbols, for simultaneous error protection it holds good that $(n-k) \geq 2t+d+e$. Often multiple Reed-Solomon codes are used. Two principles are known in this respect. According to the interleaving principle, successive symbols of a code word of a first code are distributed, by introducing respective, different delays, between a number of code words of a second code, said number being equal, for example to the number of symbols contained in a code word of the first code. In accordance with the product code principle, a group of data symbols is divided into subgroups in two or more different manners, a code word being formed from each sub-group by the addition of redundant symbols (one or more per sub-group). At least a substantial part of the code symbols then belongs to two (or possibly more) different code words. The channel symbols comply with given restrictions in order to adapt the information stream to the transmission capacity of the channel.

Examples of such restrictions are:

a lower limit exists as regards the distance between two successive signal transistions in the channel,

an aupper limit exists as regards this distance,

the channel signal has no or only a small DC component,

furthermore, given channel symbols may be forbidden for other reasons.

In accordance with said state of the art, successive channel symbols are separated by three spacing bits, but in other applications more or less spacing bits may be present. Furthermore, the modulation rules may be based on completely different rules, for example on the n-out-of-n principle.

According to said Patent Application, fourteen-bit channel symbols are converted into eight-bit code symbols during demodulation. Furthermore, a flag bit indicates whether the demodulation is reliable or unreliable. The latter indication is given when the channel symbol does not comply with one or more of the above restrictions. The spacing bits which must also satisfy the modulation rules may be taken into account for the evaluation of the quality or not. It may be that the quality is also determined of the basis of other properties of the channel signal, for example the frequency spectrum, the presence of sufficient signal power for a given frequency band, and so on. The indication given by the flag may have three or more possible values.

Upon decoding, usually first the syndrome symbols are formed and on the basis thereof it is decided whether or not a correction is necessary. The correction can usually be performed correctly. It is alternatively possible (see the equation for the error protection capability) to refrain from using the complete correction capability in favour of error detection. The reliability of the relevant symbol is then symbol-wise indicated as good or not good, possibly by means of an indication having three or more values. It may also occur that correction as well as specification of suspect symbols is impossible, because the code word contains too many incorrect symbols. In that case all symbols of the relevant code word are indicated as being unreliable, though many of the symbols thus indicated may actually be correct. In a code word of a subsequent code, a symbol so indicated will occur again in isolated manner. Correction can then be performed again, correction plus detection, or the entire code word can be indicated as being unreliable. The reference has double storage of identical codewords, separate decoding of both versions, and selection on a wordwise basis among the two decoded versions. Effectively, the channel capacity is halved. The present invention, however, is not restricted to the realization of the citation, but can be used in many different realizations. Among other things, it is an object of the invention to enhance the decoding reliability and to restrict the additional effort required, such as calculation time, for this purpose, while offering a high probability that the decoding will be correct during a second read operation. This object is achieved in accordance with a first aspect of the invention in that it is characterized in that, in case of a non-reliably decoded symbol, the information stream is accessed again while replacing any code symbol by a newly demodulated specimen of the same code symbol under control of the value of said decode flag indicating a non-reliably decoded symbol, while ignoring all other channel symbols received. In certain cases unreliable demodulation will be sufficiently indicative. In other cases replacement may be controlled by the unreliable decoding.

By itself, US 4251863 describes reaccessing of a read-write memory. If the correction is unsuccessful, but the unreliable word has been identified, a test for stuck-at faults is effected by applying mutually inverse test patterns. If such a stuck-at fault is found, the earlier, incorrected fault may be remedied by inversion. However, the present invention does not relate to such time consuming test procedures that are feasible in a matrix-type environment but relates to a retry in a channel-type organization. The physical basis for the invention is the recognition that disturbances often be temporary, such as caused by electrostatic noise.

Furthermore, Electronic Engineering, Vol. 55, No. 682, October 1983, pages 47—49 describes a microfloppy disc drive executing rewriting in a floppy disc. Rewriting in a channel organization is an inherent impossibility.

In given embodiments it is attractive when a collected code symbol is replaced only when the corresponding, newly demodulated symbol is indicated as having been reliably demodulated. The replacement of all unreliable code symbols does not necessitate the advance signalling of the reliability of the demodulation during the second read operation. The exclusive replacement by correctly demodulated code symbols sometimes implies a smaller number of write operations in the intermediate memory. A further advantage is obtained because any modifications of the content of a symbol also has an effect on the content of an associated syndrome symbol, so that the replacement of unreliable information by other unreliable information requires additional calculation time; the latter, superfluous, calculation time is now saved.

When the information stream is protected by at least one earlier and one later Reed-Solomon code are formed from decoded code symbols or code words of the earlier Reed-Solomon code, the second indicator flag is preferably assigned upon decoding of a code word of the later Reed-Solomon code. The latter implementation is notably advantageous when the later Reed-Solomon code is not the last one, i.e., when three or even more than three successive Reed-Solomon codes are involved.

In given circumstances it may then be advantageous when the later symbol correction code generates a second symbol-wise indicator flag in order to indicate an unreliable symbol and when the earlier symbol-correction code generates a third symbol-wise indicator flag, the replacement being controlled by coincidence of a second and a third indicator flag for a relevant symbol. This is notably attractive when one of the indicator flags is assigned for all symbols of a complete code word.

The invention also relates to a device for performing the method as described in the further Claims.

Brief description of a preferred embodiment

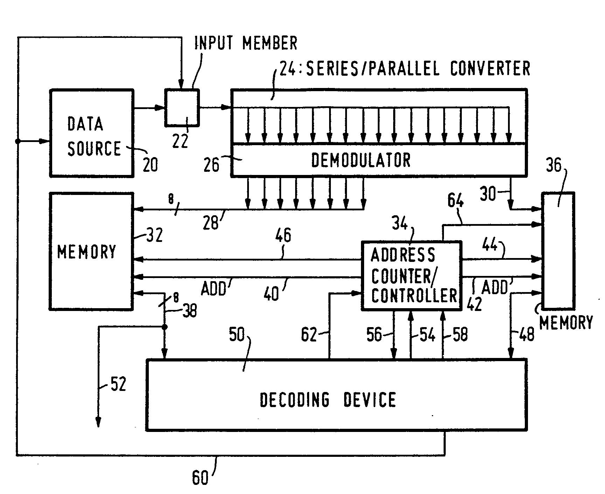

The present invention will now be described, by way of example, with reference to the single figure of the accompanying drawing, which figure shows a device in accordance with the invention.

Block 20 in the figure represents a data source. This may be a data connection to a transmitter station, a storage medium, for example a tape recorder, a playback apparatus for a disc-shaped storage member or otherwise. The storage medium may be of a read-only type or of a read-write type. The information detection can be magnetic, optical or otherwise. In the case of a disc-shaped medium, a rotary drive is provided. The same information can then be addressed again during the next revolution. In the case of a tape-shape medium there will be a winding and rewinding facility. When the medium is a transmitter station, a mechanism will be provided for requesting the transmitter station to repeat the transmission of a specific quantity of information. The medium may also have random access memory (RAM) features. Element 22 is an input member which receives a signal from the information source and which comprises suitable input equipment for this purpose, for example an aerial, a magnetic read head or a laser-type read member, depending on the medium, and also an amplifier member, discriminator and the like in order to output a stream of channel bits on its output. There is also provided a synchronization mechanism which, however, has been omitted for the sake of simplicity; the connections thereof to the other parts of device have also been omitted.

The demodulation mechanism of machines based on the "Compact Disc" will be described by way of example. In the case of audio data, processing must take place in real time, and emergency steps are feasible should the correction be impossible. Such an emergency step would be to abstain from converting into an audio signal a data symbol which is known to be incorrect; the audio signal is determined instead from one or more neighbouring, correct audio signal values by way of an interpolation mechanism. for the storage of data, real-time processing of the information received is not strictly necessary, but then the requirements imposed as regards appropriate correction are more severe because the interpolation principle does not function. Therefore, it has been proposed to provide a further error protection level, again utilizing Reed-Solomon codes, as in GB—A—2 156 555. Corresponding arguments hold good for the further processing. The "Compact-Disc" code itself will first be described.

Element 24 is a series-parallel converter which presents in parallel seventeen successive channel bits as a channel symbol plus three spacing bits to a demodulator 26. The modulation restriction is that the "run length" between successive signal transitions in the stream of channel bits may not be less than three bit cells and not more then eleven bit cells. The spacing bits also satisfy the modulation rule and minimize the DC component of the channel signal. The demodulator comprises, for example, a read-only memory of programmable logic array having 17 inputs. If the channel symbol cum spacing bits satisfy the modulation rules, the associated eight-bit code symbol is output on line 28 and a reliability flag "OK" appears on line 30. When the modulation rules are not satisfied, the symbol HEX00 appears on the line 28 and a flag $\overline{OK}$ on the line 30. Element 34 is an address counter/address control device. This device addresses memories 32 and 36 by way of identical addresses on lines 40 and 42, respectively, and thus compensates for the known interleaving effects of the storage on said "Compact Disc". Successive symbols of a code word are thus stored in successive locations in the memory; however, this is not strictly necessary. In reaction thereto, each time a write control signal appears on lines 46, 30. When the relevant code word has been completely received, the address counter/address control device 34 applies a signal "ready" to a decoding device 50 via line 56. The code symbols are then successively applied to the decoding device, via the lines 38, 48, using read control signals on lines 46, 44. The decoding operation itself will not be described in detail herein; in this respect reference is made to the previous Netherlands Patent Application 8400630 (PHN 10.931), US Patent Application Ser. No. 653255, in the name of Applicant, which application is incorporated herein by way of reference. The flag information on the line 48 can then act as locator information for suspect symbols. The decoding commences by the determination of the syndrome symbols, and in many cases these symbols will indicate that no error has occurred. The determination of the syndrome symbols can in principle commence as soon as any code symbol of the relevant code word is present. If no error has occurred, the code symbols (minus redundant symbols) can be applied to a user device via line 52, and a further signal OK will appear on line 54. Any necessary correction can be performed in the decoding device. It is alternatively possible to calculate only the corrections and to fetch only the symbols to be corrected once more from the memory 32 for this purpose. The memory addresses to be generated for this purpose by the encoding device are applied, via connection 62, to the control device 34 which applies these addresses to the memory 32. If necessary, after correction an indicator flag relating to the relevant symbol can be set to the state "reliable". Another solution is to maintain the original indicator flag and to use an additional indicator flag to indicate that the relevant code symbol has been corrected. After completion of the correction, the relevant word can be output again via the line 52. As described in said Netherlands Patent Application 8400630, the correction is performed first by means of an earlier symbol-correction code, a reliability indication thus being symbol-wise assigned. Actually, a complete code word is indicated as being reliable. Subsequently, the symbols of the code word are interleaved between a corresponding number of code words of a later symbol-correction code. The latter code word is then decoded while utilizing the reliability indications formed during decoding of the earlier code, because these indications now act as locators. Again a complete code word can be decoded or signalled as being unreliable. A reliability indication is again assigned to each decoded symbol. When the word is uncorrectable because of an excessively large number of incorrect symbols and/or erase symbols, the information "repeat" appears on the lines 58/60 when this situation is detected in the decoding device. Consequently, in a rotary system, a waiting period occurs to present the same information locations in the next revolution to the pick-up element (so-called revolution error) so that the mean processing speed is reduced. This will not be objectionable in many cases, because the time required for the processing of seriously incorrect code words is in any case much longer than the presentation time to the element 22. When this occurs several times in succession, an overflow condition arises in the memories 32, 36 and a further waiting period must be inserted until free locations become available again. When a "repeat" operation is initiated, the read head is maintained in its original radial position with respect to the disc or is returned thereto. Subsequently, the channel symbols are read and demodulated again. The address counter 34 is reset to a previous position which corresponds to the position during previous presentation of the relevant symbols. At the word level this previous position is detected by given synchronization information which is also stored on the disc. This information may be, for example a starting or index angle information which passes the head once during each revolution. Alternatively, a synchronization pattern may be stored several times per revolution, said patterns being detected by a detection circuit and being counted by a separate counter which has been omitted for the sake of simplicity. The storage pattern of the information in the intermediate memory 32, for example, can be repeated exactly once per revolution; the memory 32 then has a capacity corresponding to all code symbols of one revolution. Alternatively, the storage capacity of the memory 32 may be smaller. In that case several strategies are feasible. One solution is to continue the decoding permanently and to provide an index memory in the control device 35 which ascertains which word locations in the memory 32 are occupied by still insufficiently decoded words. The identity can be represented as a relative address with respect to the starting index. The search for a new empty word location can be associatively performed in this index memory.

During such repeats the memory 36 operates in a read/modify/write mode. The memory 32 operates in a conditional write mode. When the indication bit in the memory 36 indicates that demodulation was reliable for the relevant symbol, the control signal "no operation" (NOP) appears on the line 44. The same signal appears in the write (second) part of the memory cycle for the memory 36. When the indication bit in the memory 36 indicates that the relevant code symbol was unreliable, the control signal "write" (WR) appears on the line 44. For the memory 36 the new value of the indicator flag is written during the second part of the memory cycle. Generally, the demodulation will now be reliable in the case of "soft" errors. In some cases, notably in the case of "hard" errors, the demodulation will again be unreliable. The write operation in the memory 32 can then also be inhibited. A special advantage can be obtained when a separate memory is provided for the storage of the addresses of the modified code symbols. This can be performed if desired, by providing a separate bit in the memory 36 which then has a width of two (or more) bits, said additional bit being associatively interrogated. The further determination of the remaining modifications is thus facilitated.

The foregoing can be used in a similar manner for the various levels of Reed-Solomon codes. In some cases the code symbols of all sub-groups of a said group which were unreliably decoded or demodulated can be stored again during a second read operation. This is because it has been found that the correction capability within the group as a whole exhibits a given coherence between the sub-groups or code words: for a given code word it is co-dependent on the number of errors in words having one or more code symbols in common with previously said word. The advantage of modifying only previously unreliably demodulated symbols always consists in that the total number of errors is reduced. In some cases the calculation can also be simplified by taking into account the contribution of the modified symbols as a differential quantity in the calculations. Many calculation steps are thus simplified during the second read operation.

The described strategy can be extended in that a code word of a later code is found to be non-decodable, so that all symbols are indicated as being unreliable. In that case only the code symbols which have been signalled to be unreliable by an earlier code are deemed to qualify for the repeated read operation. Such coincidence is logically expressed as an AND-function. The actual repeated inputting can be conditionally controlled again by a signal "correctly demodulated".

## Claims

1. A method for decoding an information stream comprising a succession of channel symbols that are wordwise protected by a symbol-correcting code, said method comprising the steps of:

a. demodulating said channel symbols to associated code symbols and collecting the code symbols in an intermediate memory until a complete code word is present;

b. decoding and, if possible and necessary, correcting the code word by means of redundancy symbols which are included in the code symbols, with indicating by means of a decode flag the decoding reliability, said decode flag having a value which is different for a reliably decoded symbol versus a non-reliably decoded symbol,

characterized in that in case of a non-reliably decoded symbol, the information stream is accessed again while replacing any code symbol by a newly demodulated specimen of the same code symbol under control of the value of said decode flag indicating a non-reliably decoded symbol, while ignoring all other channel symbols received.

2. A method for decoding an information stream comprising a succession of channel symbols that are wordwise protected by a symbol-correcting code, said method comprising the steps of:

a. demodulating said channel symbols to associated code symbols while signalling the demodulation reliability of a code symbol by an associated demodulation flag, said demodulation flag having a value that is different for a reliably demodulated symbol versus a non-reliably demodulated symbol, and collecting the code symbols in an intermediate memory until a complete code word is present;

b. decoding and, if possible and necessary, correcting the code word by means of redundancy symbols which are included in the code symbols, while retaining the demodulation flag pertaining to the symbol in question, and with indicating by means of a decode flag the decoding reliability, said decode flag having a value which is different for a reliably decoded code word versus a non-reliably decoded word,

characterized in that in case of a non-reliably decoded word the information stream is accessed again while replacing any code symbol by a newly demodulated specimen of the same code word under control of the value of said demodulating flag indicating a non-reliably demodulated symbol, while ignoring all other channel symbols received.

3. A method as claimed in Claim 1 or 2, characterized in that a collected code symbol is replaced only if the corresponding, newly demodulated symbol is indicated as having been reliably demodulated.

4. A method as claimed in Claim 1, 2 or 3, in which the information stream is at least temporarily protected by an earlier and a later symbol-correction code, code words of the later symbol correction code being formed from decoded code symbols of code words of the earlier symbol-correction code, characterized in that the decode flag is assigned upon decoding of a code word of the later symbol-correction code.

5. A method as claimed in Claim 4, in which a third indicator flag is symbol-wise assigned to an unreliable symbol in the case of unreliable decoding of a code word of the earlier symbol-correction code, said replacement being controlled by coincidence of a decode flag and a third indicator flag for a relevant symbol.

6. A device for decoding an information stream comprising a succession of channel symbols that are wordwise protected by a symbol-correcting code, said device comprising:

a. a demodulator (26) for receiving said channel symbols for demodulating to code symbols for storage in an intermediate memory (32) until a complete code word is present;

b. a decoder (50) fed by the memory for decoding and, if possible and necessary, correcting the code word by means of redundancy symbols which are included in the code symbols, and having a decode flag output for a decode flag having a value that is different for a reliably decoded symbol versus a non-reliably decoded symbol,

characterized in that there is provided a control element (34, 50) for controlling a repeat mode, which control element comprises an activation input that is connected to said decode flag output, for in said repeat mode accessing again said succession of channel symbols, for activating for any code symbol a newly demodulated specimen of the same code symbol under control of the value of said decode flag indicating a non-reliably decoded symbol while ignoring all other channel symbols received.

7. A device for decoding an information stream comprising a succession of channel symbols that are wordwise protected by a symbol-correcting code, said device comprising:

a. a demodulator (26) for receiving said channel symbols for demodulating to code symbols, while signalling a demodulation flag on a demodulation flag output (30) having a value that is different for a reliably demodulated symbol versus a non-reliably demodulated symbol, for storage in an intermediate memory (32, 36) until a complete code word is present.

b. a decoder (50) fed by the memory for decoding and, if possible and necessary, correcting the code word by means of redundancy symbols which are included in the code symbols, and having a decode flag output for a decode flag having a value that is different for a reliably decoded symbol versus a non-reliably decoded symbol,

characterized in that there is a control element for (34, 50) controlling a repeat mode, which control element comprises an activation input that is connected to said decode flag output, for in said repeat mode accessing again said succession of channel symbols, for activating for any code symbol a newly demodulated specimen of the same code symbol under control of the value of said demodulation flag indicating a non-reliably demodulated symbol, while ignoring all other symbols received.

8. A device as claimed in Claim 6 or 7, characterized in that the control element enables the replacement operation only for a code symbol which has been reliably demodulated during the repeat operation.

9. A device as claimed in Claim 6, 7 or 8, in which the information stream is protected by at least one earlier and one later symbol-correcting code, code words of the later symbol-correcting code being formed from decoded code symbols of code words of the earlier symbol-correcting code, characterized in that said detector is activated by decode flags assigned upon decoding of code words of the later symbol-correcting code.

10. A device as claimed in Claim 9, in which a third indicator flag is symbol-wise assigned to an unreliable symbol in the case of unreliable decoding of a code word of the earlier symbol-correction code, characterized in that there is provided a coincidence detector for receiving said decode and third indicator flags and for forming an enable signal for a replacement operation for the relevant symbol only in the case of coincidence thereof for a given symbol.

**Patentansprüche**

1. Verfahren zum Decodieren eines Informationsflusses mit einer Aufeinanderfolge von Kanalsymbolen, die durch einen Symbolkorrekturcode wortweise geschützt sind, und dieses Verfahren umfaßt folgende Schritte:

a. Demodulieren der Kanalsymbole in zugehörige Codesymbole und Sammeln der Codesymbole in einem Zwischenspeicher, bis sich ein komplettes Codewort gebildet hat;

b. Decodieren und, wenn möglich und erforderlich, Korrigieren des Codeworts mittels in die Codesymbole aufgenommener Redundanzsymbole unter Angabe der Decodierzuverlassigkeit mittels eines Decodierkennzeichens, dessen Wert für ein zuverlässig decodiertes Symbol gegenüber einem unzuverlässig decodierten Symbol abweicht,

dadurch gekennzeichnet, daß bei einem unzuverlässig decodierten Symbol der Informationsfluß wieder angesprochen wird, während ein Codesymbol durch eine neu demodulierte Probe desselben Codesymbols unter der Steuerung des Wertes des Decodierkennzeichens ersetzt wird, das ein unzuverlässig decodiertes Symbol anzeigt, während alle anderen empfangenen Kanalsymbole ignoriert werden.

2. Verfahren zum Decodieren eines Informationsflusses mit einer Aufeinanderfolge von Kanalsymbolen, die durch einen Symbolkorrekturcode wortweise geschützt sind, und dieses Verfahren umfaßt folgende Schritte:

a. Demodulieren der Kanalsymbole in zugehörige Codesymbole unter gleichzeitiger Signalisierung der Demodulationszuverlässigkeit eines Codesymbols durch ein zugeordnetes Demodulationskennzeichen, wobei das Demodulationskennzeichen einen für ein zuverlassig demoduliertes Symbol gegenüber einem unzuverlässig demodulierten Symbol abweichenden Wert besitzt, und Sammeln der Codesymbole in einem Zwischenspeicher, bis sich ein komplettes Codewort gebildet hat;

b. Decodieren und, wenn möglich und erforderlich, Korrigieren des Codeworts mittels in die Codesymbole aufgenommener Redundanzsymbole, während des Demodulationskennzeichen festgehalten wird, das zum betreffenden Symbol gehört, und unter Angabe der Decodierzuverlässigkeit mittels eines Decodierkennzeichens, dessen Wert für ein zuverlässig decodiertes Codewort gegenüber einem unzuverlässig decodierten Wort abweicht,

dadurch gekennzeichnet, daß bei einem unzuverlässig decodierten Wort der Informationsfluß wieder angesprochen wird, während ein Codesymbol durch eine neu demodulierte Probe desselben Codeworts unter der Steuerung des Wertes des Demodulationskennzeichens ersetzt wird, das ein unzuverlässig demoduliertes Symbol anzeigt, während alle anderen empfangenen Kanalsymbole ignoriert werden.

3. Verfahren nach Anspruch 1 oder 2, dadurch gekennzeichnet, daß ein gesammeltes Codesymbol nur dann ersetzt wird, wenn das entsprechende, neu demodulierte Symbol als zuverlässig demoduliert angezeigt wird.

4. Verfahren nach Anspruch 1, 2 oder 3, bei dem der Informationsfluß wenigstens vorübergehend von einem früheren und einem späteren Symbolkorrekturcode geschützt wird, wobei Codewörter des späteren Symbolkorrekturcodes aus decodierten Codesymbolen von Codewörtern des früheren Symbolkorrekturcodes gebildet werden, dadurch gekennzeichnet, daß das Decodierkennzeichen beim Decodieren eines Codeworts des späteren Symbolkorrekturcodes zugeweisen wird.

5. Verfahren nach Anspruch 4, bei dem ein drittes Anzeige-Kennzeichen bei unzuverlässigem Decodieren eines Codeworts des früheren Symbolkorrekturcodes einem unzuverlässigen Symbol symbolartig zugeweisen wird, wobei der Ersatz durch Zusammenfallen eines Decodierkennzeichens und eines dritten Anzeige-Kennzeichens für ein relevantes Symbol gesteuert wird.

6. Gerät zum Decodieren eines Informationsflusses, der eine Aufeinanderfolge von Kanalsymbolen enthält, die von einem Symbolkorrekturcode wortweise geschützt werden, wobei das Gerät folgende Elemente enthält:

a. einen Demodulator (26) zum Empfangen der Kanalsymbole zum Demodulieren nach Codesymbolen zur Speicherung in einem Zwischenspeicher (32), bis ein vollständiges Codewort vorliegt;

b. einen vom Speicher gespeisten Decoder (50) zum Decodieren und, falls möglich und erforderlich, zum Korrigieren des Codeworts mittels in die Codesymbole aufgenommener Redundanzsymbole, mit einem Decodierkennzeichenausgang für ein Decodierkennzeichen mit einem Wert, der für ein zuverlässig decodiertes Symbol gegenüber einem unzuverlässig decodierten Symbol abweicht,

dadurch gekennzeichnet, daß ein Steuerelement (34, 50) zum Steuern eines Wiederholungsbetriebs vorgesehen ist, das einen mit dem Decodierkennzeichenausgang verbundenen Aktivierungseingang zum erneuten Ansprechen der Aufeinanderfolge von Kanalsymbolen im Wiederholungsbetrieb und zum Aktivieren einer neu demodulierten Probe desselben Codesymbols für ein Codesymbol unter der Steuerung des Werts des Decodierkennzeichens enthält, das ein unzuverlässig decodiertes Symbol anzeigt unter gleichzeitigem Ignorieren aller anderen empfangenen Kanalsymbole.

7. Gerät zum Decodieren eines Informationsflusses, der eine Aufeinanderfolge von Kanalsymbolen enthält, die von einem Symbolkorrekturcode wortweisae geschützt werden, wobei das Gerät folgende Elemente enthält;

a. einen Demodulator (26) zum Empfangen der Kanalsymbole zum Demodulatieren nach Codesymbolen bei gleichzeitiger Signalisierung eines Demodulationskennzeichens an einem Demodulationskennzeichenausgang (30) mit einem Wert, der für ein zuverlässig demoduliertes Symbol gegenüber einem unzuverlässig demodulierten Symbol abweicht, und zur Speicherung in einem Zwischenspeicher (32, 36), bis ein vollständiges Codewort vorliegt;

b. einen vom Speicher gespeisten Decoder (50) zum Decodieren und, falls möglich und erforderlich, zum Korrigieren des Codeworts mittels in die Codesymbols aufgenommener Redundanzsymbole, mit einem Decodierkennzeichenausgang für ein Decodierkennzeichen mit einem Wert, der für ein zuverlässig decodiertes Symbol gegenüber einem unzuverlässig decodierten Symbol abweicht,

dadurch gekennzeichnet, daß ein Steuerelement (34, 50) zum Steuern eines Wiederholungsbetriebs vorgesehen ist, das einen mit dem Decodierkennzeichenausgang verbundenen Aktivierungseingang zum erneuten Ansprechen der Aufeinanderfolge von Kanalsymbolen im Wiederholungsbetrieb und zum Aktivieren einer neu demodulierten Probe desselben Codesymbols für ein Codesymbol unter der Steuerung des Werts des Demodulationskennzeichens, das ein unzuverlässig demoduliertes Symbol anzeigt unter gleichzeitigem Ignorieren aller anderen empfangenen Kanalsymbole.

8. Gerät nach Anspruch 6 oder 7, dadurch gekennzeichnet, daß das Steuerelement die Ersatzoperation nur für ein Codesymbol ermöglicht, das während der Wiederholungsoperation zuverlässig demoduliert wurde.

9. Gerät nach Anspruch 6, 7 oder 8, in dem der Informationsfluß wenigstens von einem früheren und von einem späteren Symbolkorrekturcode geschützt wird, wobei Codewörter des späteren Symbolkorrekturcodes aus decodierten Codesymbolen von Codewörtern des früheren Symbolkorrekturcodes gebildet werden, dadurch gekennzeichnet, daß der Detektor durch Decodierkennzeichen aktiviert wird, die beim Decodieren von Codewörtern des späteren Symbolkorrekturcodes zugewiesen wurden.

10. Gerät nach Anspruch 9, in dem ein drittes Anzeige-Kennzeichen einem unzuverlässigen Symbol bei unzuverlässiger Decodierung eines Codeworts des früheren Symbolkorrekturcodes zugewiesen wird, dadurch gekennzeichnet, daß ein Koinzidenzdetektor zum Empfangen der Decodier- und Drittenzeige-Kennzeichen und zur Bildung eines Freigabesignals für eine Ersatzoperation für das relevante Symbol nur beim Zusammenfallen dieser Kennzeichen für ein gegebenes Symbol vorgesehen ist.

## Revendications

1. Méthode pour le décodage d'une suite d'informations comprenant une succession de symboles de canal qui sont protégés mot par mot par un code de correction de symboles, cette méthode comprenant les étapes suivantes:

a. démodulation des symboles de canal en des symboles de code associés et collecte des symboles de code dans une mémoire intermédiaire jusqu'à ce qu'un mot de code complet soit présent;

b. décodage et, si possible et nécessaire, correction du mot de code à l'aide de symboles de redondance qui sont inclus dans les symboles de code, tout en indiquant la fiabilité du décodage à l'aide d'un fanion de décodage, le fanion de décodage ayant une valeur qui est différente pour un symbole décodé de manière fiable et pour un symbole décodé de manière non fiable;

caractérisée en ce que dans le cas d'un symbole décodé de manière non fiable, la suite d'informations fait l'objet d'un réaccès, tandis qu'un symbole de code quelconque est remplacé par un échantillon nouvellement démodulé du même symbole de code sous la commande de la valeur du fanion de décodage indiquant un symbole décodé de manière non fiable, tout en ignorant tous les autres symboles de canal reçus.

2. Méthode pour le décodage d'une suite d'informations comprenant une succession de symboles de canal qui sont protégés mot par mot par un code de correction de symboles, cette méthode comprenant les étapes suivantes:

a. démodulation des symboles de canal en des symboles de code associés avec signalisation de la fiabilité de démodulation d'un symbole de code par un fanion de démodulation associé, le fanion de démodulation ayant une valeur qui est différente pour un symbole démodulé de manière fiable et pour un symbole démodulé de manière non fiable, et collecte des symboles de code dans une mémoire intermédiaire jusqu'à ce qu'un mot de code complet soit présent;

b. décodage et, si possible et nécessaire, correction du mot de code à l'aide de symboles de redondance qui sont inclus dans les symboles de code en retenant le fanion de démodulation se rapportant au symbole en question, tout en indiquant la fiabilité du décodage à l'aide d'un fanion de décodage, le fanion de décodage ayant une valeur qui est différente pour un mot de code décodé de manière fiable de pour un mot de code décodé de manière non fiable;

caractérisée en ce que dans le cas d'un mot de code décodé de manière non fiable, la suite d'informations fait l'objet d'un réaccès, tandis qu'un symbole de code quelconque est remplacé par un échantillon nouvellement démodulé du même mot de code sous la commande de la valeur du fanion de démodulation indiquant un symbole démodulé de manière non fiable, tout en ignorant tous les autres symboles de canal reçus.

3. Méthode suivant la revendication 1 ou 2, caractérisée en ce qu'un symbole de code collecté n'est remplacé que si le symbole nouvellement démodulé correspondant est indiqué comme ayant été démodulé de manière fiable.

4. Méthode suivant la revendication 1, 2 ou 3, dans laquelle la suite d'informations est au moins temporairement protégée par un code de correction de symboles antérieur et un code de correction de symboles postérieur, des mots de code du code de correction de symboles postérieur étant formés à partir de symboles de code décodés de mot de code du code de correction de symboles antérieur, caractérisée en ce que le fanion de décodage est attribué lors du décodage d'un mot de code du code de correction de symboles postérieur.

5. Méthode suivant la revendication 4, dans laquelle un troisième fanion indicateur est attribué, symbole par symbole, à un symbole non fiable dans le cas d'un décodage non fiable d'un mot de code du code de correction de symboles antérieur, le remplacement étant commandé par la coincidence d'un fanion de décodage et d'un troisième fanion indicateur pour un symbole en question.

6. Dispositif pour le décodage d'une suite d'informations comprenant une succession de symboles de canal qui sont protégés mot par mot par un code de correction de symboles, ce dispositif comprenant:

a. un démodulateur (26) destiné à recevoir les symboles de canal en vue de les démoduler en symboles de code à stocker dans une mémoire intermédiaire (32) jusqu'à ce qu'un mot de code complet soit présent;

b. un décodeur (50) alimenté par la mémoire pour le décodage et, si possible et nécessaire, la correction du mot de code à l'aide de symboles de redondance qui sont inclus dans les symboles de code, et comportant une sortie de fanion de décodage pour un fanion de décodage ayant une valeur différente pour un symbole décodé de manière fiable et pour un symbole décodé de manière non fiable;

caractérisé en ce qu'il est prévu un élément de commande (34, 50) destiné à commander un mode de répétition, cet élément de commande comprenant une entrée d'activation qui est connectée à la sortie de fanion de décodage pour, dans le mode de répétition, accéder à nouveau à la succession de symboles de canal, afin d'activer pour tout symbole de code un échantillon nouvellement démodulé du même symbole de code sous la commande de la valeur du fanion de décodage indiquant un symbole décodé de manière non fiable tout en ignorant tous les autres symboles de canal reçus.

7. Dispositif pour le décodage d'une suite d'informations comprenant une succession de symboles de canal qui sont protégés mot par mot par un code de correction de symboles, ce dispositif comprenant:

a. un démodulateur (26) destiné à recevoir les symboles de canal pour les démoduler en symboles de code tout en signalant un fanion de démodulation sur une sortie de fanion de démodulation (30) ayant une valeur qui est différente pour un symbole démodulé de manière fiable et pour un symbole démodulé de manière non fiable, en vue d'un stockage dans une mémoire intermédiaire (32, 36) jusqu'à ce qu'un mot complet soit présent;

b. un décodeur (50) alimenté par la mémoire pour le décodage et, si possible et nécessaire, la correction du mot de code à l'aide de symboles de redondance qui sont inclus dans les symboles de code et comportant une sortie de fanion de décodage pour un fanion de décodage ayant une valeur qui est différente pour un symbole décodé de manière fiable et pour un symbole décodé de manière non fiable;

caractérisé en ce qu'un élément de commande est prévu pour (34, 50) commander un mode de répétition, cet élément de commande comprenant une entrée d'activation qui est connectée à la sortie de fanion de décodage pour, dans le mode de répétition, accéder à nouveau à la succession de symboles de canal, en vue d'activer pour tout symbole de code, un échantillon nouvellement démodulé du même symbole de code sous la commande de la valeur du fanion de démodulation indiquant un symbole démodule de manière non fiable, tout en ignorant tous les autres symboles reçus.

8. Dispositif suivant la revendication 6 ou 7, caractérisé en ce que l'élément de commande ne permet l'opération de remplacement que pour un symbole de code qui a été démodulé de manière fiable pendant l'opération de répétition.

9. Dispositif suivant la revendication 6, 7 ou 8, dans lequel la suite d'informations est protégée par au moins un code de correction de symboles antérieur et un code de correction de symboles postérieur, des mots de code du code de correction de symboles postérieur étant formés à partir de symboles de code décodés de mots de code du code de correction de symboles antérieur, caractérisé en ce que le détecteur est activé par des fanions de décodage attribués lors du décodage de mots de code du code de correction de symboles postérieur.

10. Dispositif suivant la revendication 9, dans lequel un troisième fanion indicateur est attribué, symbole par symbole, à un symbole non fiable dans le cas du décodage non fiable d'un mot de code du code de correction de symboles antérieur, caractérisé en ce qu'un détecteur de coincidence est prévu puor recevoir le fanion de décodage et le troisième fanion indicateur et pour ne former un signal de validation pour une opération de remplacement pour le symbole en question que dans le cas de leur coincidence pour un symbole donné.